(19) Europäisches Patentamt
European Patent Office
Office européen des brevets

(11) **EP 3 510 598 B1**

(12) **FASCICULE DE BREVET EUROPEEN**

(45) Date de publication et mention
de la délivrance du brevet:
**30.09.2020 Bulletin 2020/40**

(21) Numéro de dépôt: **17761901.2**

(22) Date de dépôt: **08.09.2017**

(51) Int Cl.:
*G11C 13/00* (2006.01)   *G11C 11/16* (2006.01)
*H01L 27/24* (2006.01)   *H01L 45/00* (2006.01)

(86) Numéro de dépôt international:
**PCT/EP2017/072621**

(87) Numéro de publication internationale:
**WO 2018/046682 (15.03.2018 Gazette 2018/11)**

(54) **DISPOSITIF DE SÉLECTION D'UNE CELLULE MÉMOIRE**

VORRICHTUNG ZUR AUSWAHL EINER SPEICHERZELLE

DEVICE FOR SELECTING A STORAGE CELL

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **09.09.2016 FR 1658444**

(43) Date de publication de la demande:
**17.07.2019 Bulletin 2019/29**

(73) Titulaire: **Commissariat à l'Énergie Atomique
et aux Énergies Alternatives
75015 Paris (FR)**

(72) Inventeurs:
• **BARLAS, Marios
38400 St Martin d'Hères (FR)**
• **BLAISE, Philippe
38000 Grenoble (FR)**
• **GRENOUILLET, Laurent
38640 Claix (FR)**
• **SKLENARD, Benoit
38100 Grenoble (FR)**
• **VIANELLO, Elisa
38000 Grenoble (FR)**

(74) Mandataire: **Cabinet Camus Lebkiri
25 rue de Maubeuge
75009 Paris (FR)**

(56) Documents cités:
**US-A1- 2010 110 765    US-A1- 2011 007 551
US-A1- 2015 263 069    US-A1- 2015 349 251**

**Description**

**DOMAINE TECHNIQUE DE L'INVENTION**

Le domaine technique de l'invention est celui des mémoires non-volatiles, et plus particulièrement celui des dispositifs de sélection d'une cellule mémoire dans une matrice.

**ARRIÈRE-PLAN TECHNOLOGIQUE DE L'INVENTION**

Les mémoires non volatiles sont des mémoires qui conservent l'information même lorsqu'elles ne sont pas alimentées électriquement. Il existe plusieurs types de mémoires non volatiles communément utilisées, comme les mémoires de type flash. Cependant, ces mémoires présentent des inconvénients tels que des temps d'écritures longs et une faible densité d'intégration. De plus, elles nécessitent de travailler à des tensions d'alimentations élevées, de l'ordre de 10 à 15V.

Plus récemment, d'autres types de mémoires non volatiles sont apparus, basés sur un matériau actif, tels que les mémoires de type CBRAM, pour « Conductive Bridging Random Access Memory » en anglais, qui comportent un matériau à conduction ionique, les mémoires de type OxRAM, pour « Oxide resistive Random Access Memory » en anglais, qui comportent un matériau à oxyde métallique, et les mémoires de type PCRAM, pour « Phase Change Random Access Memory » en anglais, qui comportent un matériau à changement de phase. Ces mémoires sont des mémoires résistives, le matériau actif pouvant basculer de manière réversible entre un état à faible résistance et un état à forte résistance. Ces deux états de résistance permettent ainsi de coder un bit d'information.

Les mémoires résistives présentent des vitesses de fonctionnement suffisamment élevées pour prétendre remplacer les mémoires non volatiles actuelles telles que les mémoires de type flash. De plus, les mémoires résistives fonctionnent à des tensions d'alimentations plus faibles. Les mémoires résistives présentent également l'intérêt de pouvoir être intégrées avec une forte densité, en particulier avec une architecture de type crossbar. Une telle architecture comporte plusieurs lignes d'accès réparties en lignes de bits et en lignes de mots qui sont perpendiculaires les unes aux autres. Au niveau de chaque intersection entre une ligne de bits et une ligne de mots, une cellule mémoire est disposée entre les lignes. Chaque cellule mémoire est donc adressable individuellement en sélectionnant la ligne de bits et la ligne de mots appropriées.

Cependant, comme toutes les cellules mémoires d'une ligne de bits, et d'une ligne de mots, sont connectées électriquement les unes aux autres, il est possible d'observer des courants de fuite parasites passant par les cellules mémoires adjacentes à la cellule mémoire adressée. Ces courants de fuite peuvent perturber la lecture de la cellule mémoire adressée jusqu'à empêcher de discriminer son état de résistance, en particulier dans le cas défavorable où les cellules mémoires adjacentes se trouvent à l'état de faible résistance.

Pour remédier à ce problème, il est connu de connecter en série avec chaque cellule mémoire, un dispositif de sélection permettant d'atténuer les courants parasites. L'utilisation d'un transistor en tant que dispositif de sélection est répandue mais augmente la complexité de l'intégration, d'une part parce que le transistor présente des dimensions élevées en comparaison de celles que peut atteindre la cellule mémoire, et d'autre part parce que le transistor n'est pas intégrable avec la cellule mémoire au sein de l'architecture crossbar. Par conséquent, la densité et la capacité d'intégration, notamment en trois dimensions, est limitée.

Le document US2015/263069 A1 divulgue un dispositif de sélection d'une mémoire non-volatile résistive.

**RÉSUMÉ DE L'INVENTION**

La présente invention vise à améliorer l'intégration d'un dispositif de sélection d'une cellule mémoire non-volatile résistive.

Un premier aspect de l'invention concerne donc un dispositif de sélection d'une cellule mémoire non-volatile résistive, le dispositif de sélection comportant une première électrode, une deuxième électrode et une couche d'oxyde disposée entre la première électrode et la deuxième électrode, la couche d'oxyde étant dopée avec Z du silicium.

Le dispositif de sélection présente ainsi une structure lui permettant d'atteindre des dimensions du même ordre de grandeur que celle d'une cellule mémoire et d'être intégré dans une architecture crossbar. De plus, le comportement résistif du dispositif de sélection est modifié par le dopage de la couche d'oxyde de manière à ce que le dispositif de sélection présente une caractéristique courant-tension, c'est-à-dire une variation du courant traversant le dispositif de sélection en fonction de la tension appliquée au dispositif de sélection, fortement non-linéaire. En particulier, lorsque la tension est faible, le courant est faible, et inversement, lorsque la tension est élevée, le courant est élevé.

De préférence, la couche d'oxyde est entièrement dopée avec le silicium.

De préférence, le silicium est présent dans la couche d'oxyde à une concentration atomique comprise entre 0,5% et 3%.

La couche d'oxyde peut comporter un matériau parmi les suivants : oxyde de hafnium, oxyde de tantale.

Un deuxième aspect de l'invention concerne une cellule élémentaire comportant un dispositif selon le premier aspect de l'invention et une cellule mémoire non volatile résistive connectée en série avec le dispositif.

La cellule mémoire peut être une cellule mémoire de type OxRAM, CBRAM ou PCRAM.

Selon un mode de réalisation particulièrement avantageux, la cellule mémoire comporte une première électrode, une deuxième électrode et une couche d'oxyde disposée entre la première électrode et la deuxième électrode, la cellule mémoire et le dispositif présentant chacun une tension de formation d'une zone de commutation dans leur couche d'oxyde respective, la couche d'oxyde du dispositif étant dopée de manière à ce que la tension de formation du dispositif soit supérieure à la tension de formation de la cellule mémoire.

On entend par « zone de commutation » une zone dans laquelle la couche d'oxyde passe d'un état à forte résistance à un état à faible résistance, cette zone formant un chemin de conduction privilégié au courant traversant le dispositif de sélection ou la cellule mémoire.

Le dispositif de sélection et la cellule mémoire présentent ainsi des structures similaires. Par conséquent, la cellule mémoire et le dispositif de sélection peuvent être intégrés ensemble et être réalisés de la même manière, ce qui facilite la fabrication. De plus, en faisant en sorte que la tension de formation du dispositif soit supérieure à la tension de formation de la cellule mémoire, on évite la formation de la zone de commutation dans la couche d'oxyde du dispositif de sélection lorsque la cellule élémentaire est en fonctionnement. On préserve ainsi les propriétés résistives du dispositif de sélection.

Selon une première variante, le silicium est présent dans la couche d'oxyde du dispositif à une concentration atomique comprise entre 0,5% et 2%.

Selon une première variante, le silicium est présent dans la couche d'oxyde du dispositif à une concentration atomique supérieure à 2%, et la couche d'oxyde de la cellule mémoire est dopée avec un deuxième élément appartenant à la colonne IV de la classification périodique de manière à ce que le deuxième élément soit présent dans la couche d'oxyde de la cellule mémoire à une concentration atomique supérieure à la concentration atomique du silicium.

De préférence, la couche d'oxyde de la cellule mémoire est dopée avec du silicium.

Avantageusement, le dispositif et la cellule mémoire sont disposés sur un substrat de manière à former un empilement vertical, le dispositif étant disposé entre la cellule mémoire et le substrat.

La couche d'oxyde de la cellule mémoire peut comporter un matériau parmi les suivants : oxyde de hafnium, oxyde de tantale, oxyde de titane.

## BRÈVE DESCRIPTION DES FIGURES

L'invention et ses différentes applications seront mieux comprises à la lecture de la description qui suit et à l'examen des figures qui l'accompagnent, parmi lesquelles :

- la figure 1 représente schématiquement une vue en coupe transversale d'un mode de réalisation d'un dispositif de sélection selon l'invention ;

- la figure 2 représente des caractéristiques courant-tension du dispositif de sélection de la figure 1 qui comporte une couche d'oxyde de hafnium de 10nm d'épaisseur dopée avec du silicium, pour différentes valeurs de concentration atomique en silicium dans la couche d'oxyde de hafnium ;
- la figure 3 représente schématiquement une vue en coupe transversale d'un mode de réalisation d'une cellule élémentaire selon l'invention, la cellule élémentaire comportant le dispositif de sélection de la figure 1 ;
- la figure 4 montre la variation de la tension de formation d'une zone de commutation dans une couche d'oxyde de hafnium en fonction de la concentration atomique, exprimée en pourcentage, de silicium présent dans la couche d'oxyde de hafnium.

Les figures ne sont présentées qu'à titre indicatif et nullement limitatif de l'invention.

Pour plus de clarté, les éléments identiques ou similaires sont repérés par des signes de référence identiques sur toutes les figures.

## DESCRIPTION DÉTAILLÉE DE MODES DE REALISATION DE L'INVENTION

Un premier aspect de l'invention concerne un dispositif de sélection destiné à être connecté en série avec une cellule mémoire, telle qu'une cellule mémoire résistive pouvant basculer de manière réversible entre un état à faible résistance et un état à forte résistance. Le changement d'état de résistance de la cellule mémoire correspond à une opération de programmation (écriture ou effacement) qui est effectuée en appliquant à la cellule mémoire une tension de programmation. La cellule mémoire peut présenter une tension de programmation différente pour chaque état de résistance, notamment une tension d'écriture différente de la tension d'effacement.

Le changement d'état de résistance de la cellule mémoire peut nécessiter un courant important. Par exemple, pour une cellule mémoire de type CBRAM ou OxRAM, le changement d'état de résistance est lié à la formation et à la rupture d'une zone de commutation qui forme un chemin de conduction privilégié au courant traversant la cellule mémoire lorsque cette dernière est à l'état à faible résistance. Plus le courant qui traverse la zone de commutation est élevé, plus il est difficile de rompre la zone de commutation. Le dispositif de sélection doit donc laisser passer suffisamment de courant pour permettre au courant traversant la zone de commutation de fuir et ainsi faciliter la rupture de la zone de commutation. De manière générale, le dispositif de sélection doit laisser passer suffisamment de courant pour permettre le changement d'état de résistance de la cellule mémoire.

La détermination de l'état de résistance dans lequel se trouve la cellule mémoire correspond à une opération de lecture qui est effectuée en appliquant à la cellule mémoire une tension de lecture.

La cellule mémoire peut appartenir à une matrice mémoire présentant par exemple une architecture de type crossbar qui comporte des lignes de bits et des lignes de mots perpendiculaires les unes aux autres, une cellule mémoire étant disposée à chaque intersection entre une ligne de bits et une ligne de mots. Une cellule mémoire est adressée en écriture (respectivement en effacement) ou en lecture en appliquant la tension d'écriture (respectivement la tension d'effacement) ou la tension de lecture entre la ligne de bits et la ligne de mots appropriées.

Idéalement, pendant une opération de lecture, seule la cellule mémoire adressée est traversée par un courant. Cependant, des courants de fuite peuvent traverser les cellules mémoires adjacentes à la cellule mémoire adressée. En effet, les cellules mémoires disposées sur la ligne de bits sélectionnée sont soumises à une partie, par exemple la moitié, de la tension de lecture. Il en est de même pour les cellules mémoires disposées sur la ligne de mots sélectionnée. Les courants de fuite peuvent s'additionner au courant traversant la cellule mémoire adressée et ainsi fausser la détermination de l'état de résistance de la cellule mémoire adressée. Le dispositif de sélection doit donc isoler les cellules mémoires qui ne sont pas adressées afin d'atténuer les courants de fuite.

En résumé, le dispositif de sélection est conçu de manière à ce que, sur une plage de tension incluant les tensions de fonctionnement (écriture, effacement et lecture), le courant traversant le dispositif de sélection soit élevé, et que, pour des tensions inférieures à cette plage de tension, le courant traversant le dispositif de sélection soit faible.

Dans la suite de la description, les termes « élevée » et « faible », lorsqu'ils caractérisent une tension, sont utilisés pour désigner une tension appartenant respectivement à la plage de tension incluant les tensions de fonctionnement, et une tension inférieure à cette plage.

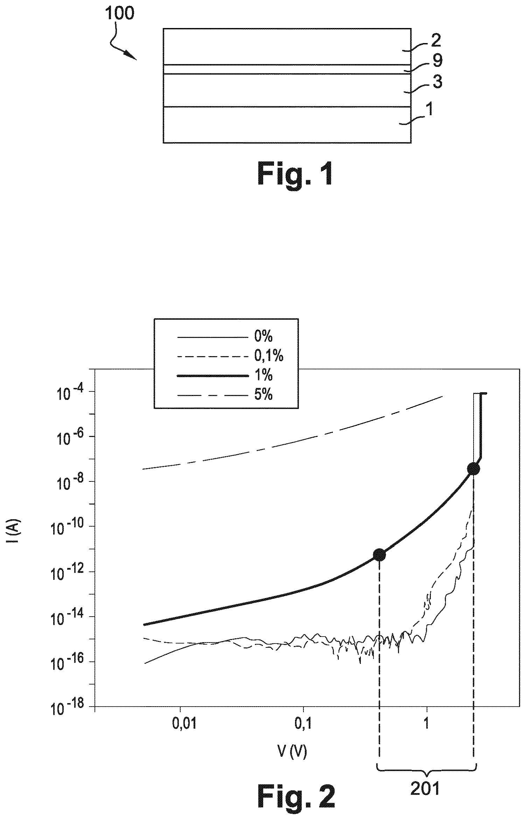

La figure 1 montre un mode de réalisation d'un dispositif de sélection 100 selon l'invention qui satisfait les caractéristiques décrites précédemment. Le dispositif de sélection 100 comporte une première électrode 1, une deuxième électrode 2 et une couche d'oxyde 3 disposée entre la première électrode 1 et la deuxième électrode 2.

Les électrodes 1, 2 sont des couches conductrices électriquement et peuvent comporter un ou plusieurs matériaux conducteurs tels que le nitrure de titane, le silicium dopé, le tungstène, le nitrure de tungstène, les siliciures de métal, le platine. Les électrodes 1, 2 présentent une épaisseur de préférence comprise entre 5nm et 30nm.

La couche d'oxyde 3 comporte de préférence un oxyde d'un métal de transition tel que l'oxyde de hafnium, l'oxyde de tantale, l'oxyde de titane, l'oxyde de zirconium ou l'oxyde de niobium. Eventuellement, la couche d'oxyde 3 peut comporter plusieurs sous-couches d'oxydes superposées. La couche d'oxyde 3 présente une épaisseur de préférence comprise entre 3nm et 20nm, et plus préférentiellement encore comprise entre 5nm et 10nm.

La couche d'oxyde 3 est dopée avec du silicium. Ce dopage permet de modifier les propriétés de résistivité du dispositif de sélection afin d'obtenir un comportement non-linéaire de la courbe de réponse du courant traversant le dispositif de sélection en fonction de la tension appliquée à la cellule mémoire. Ce comportement inclut notamment un courant faible pour une tension est faible, le dispositif de sélection 100 présentant alors une forte valeur de résistance, et un courant élevé pour une tension élevée, le dispositif de sélection 100 présentant alors une faible valeur de résistance.

De préférence, l'ensemble de la couche d'oxyde 3 du dispositif de sélection est dopée avec le silicium. La concentration atomique de cet élément est avantageusement uniforme au sein de la couche d'oxyde 3.

La figure 2 montre des caractéristiques courant-tension pour un exemple de dispositif de sélection 100 comportant une couche d'oxyde de hafnium de 10nm d'épaisseur dopée avec du silicium. Les caractéristiques courant-tension sont représentées pour différentes valeurs de concentration atomique en silicium dans la couche d'oxyde de hafnium.

Dans l'ensemble de la description et dans les revendications, la concentration atomique C de l'élément dopant dans la couche d'oxyde 3 est exprimée en pourcentage et est définie par la relation suivante :

$$C = 100 * \frac{C_{dopant}}{C_{Ox} + C_{dopant}}$$

où $C_{dopant}$ est la concentration d'atomes de l'élément dopant présents dans la couche d'oxyde 3, et $C_{Ox}$ est la concentration d'atomes constituant la couche d'oxyde 3 non dopée, ces concentrations $C_{dopant}$ et $C_{Ox}$ étant exprimées en nombre d'atomes par $cm^{-3}$.

On remarque sur la figure 2 que lorsque la concentration atomique en silicium dans la couche d'oxyde 3 est trop faible, par exemple de l'ordre de 0,1%, la caractéristique courant-tension est sensiblement identique au cas où la couche d'oxyde 3 n'est pas dopée. Dans ce cas, la caractéristique courant-tension est fortement non-linéaire mais le dispositif de sélection 100 ne laisse pas passer suffisamment de courant pour permettre de lire ou de faire basculer l'état de résistance de la cellule mémoire.

Au contraire, lorsque la concentration atomique en silicium dans la couche d'oxyde 3 est trop élevée, par exemple de l'ordre de 5%, la caractéristique courant-tension devient sensiblement linéaire. De plus, le dispositif de sélection 100 n'est plus suffisamment isolant même lorsque la tension est faible, le courant étant alors trop élevé.

Une caractéristique courant-tension satisfaisante est avantageusement obtenue lorsque la concentration atomique en silicium dans la couche d'oxyde 3 est comprise entre 0,5% et 3%, par exemple de l'ordre 1%. En effet, cette caractéristique présente une forte non-linéarité sur une plage de tension 201 suffisamment étendue pour inclure les tensions de fonctionnement de la cellule mémoire. De plus, lorsque la tension est faible, le courant est faible. Dans ce cas, le dispositif de sélection 100 peut par exemple présenter un facteur de non linéarité compris entre 100 et 5000.

La concentration atomique de l'élément dopant dans la couche d'oxyde est donc de préférence comprise entre 0,5% et 3%, et plus préférentiellement encore comprise entre 1% et 2%.

Le dopage de la couche d'oxyde 3 est de préférence obtenu par implantation ionique qui est un procédé bien contrôlé, ce qui permet d'obtenir avec précision la concentration atomique de l'élément dans la couche d'oxyde 3 désirée.

Le dispositif de sélection 100 peut avantageusement être fabriqué en utilisant uniquement des matériaux qui soient compatibles aussi bien avec une intégration en fin de ligne de production qu'une intégration en début de ligne de production. C'est le cas par exemple d'un mode de réalisation particulier dans lequel les électrodes 1, 2 du dispositif de sélection sont en nitrure de titane, la couche d'oxyde 3 du dispositif de sélection est en oxyde de hafnium et est dopée avec du silicium.

Un deuxième aspect de l'invention concerne une cellule élémentaire comportant un dispositif de sélection tel que décrit précédemment et une cellule mémoire résistive connectée en série avec le dispositif de sélection. Une multitude de telles cellules élémentaires peuvent être agencées en lignes et colonnes pour former une matrice mémoire présentant par exemple une architecture de type crossbar.

La cellule mémoire résistive peut par exemple être une cellule mémoire CBRAM, OxRAM, PCRAM ou STT-RAM. De manière générale, il peut s'agir de toute cellule mémoire qui est alternativement adressée ou isolée, et qui en fonctionnement est traversée par un courant qu'il est nécessaire de limiter.

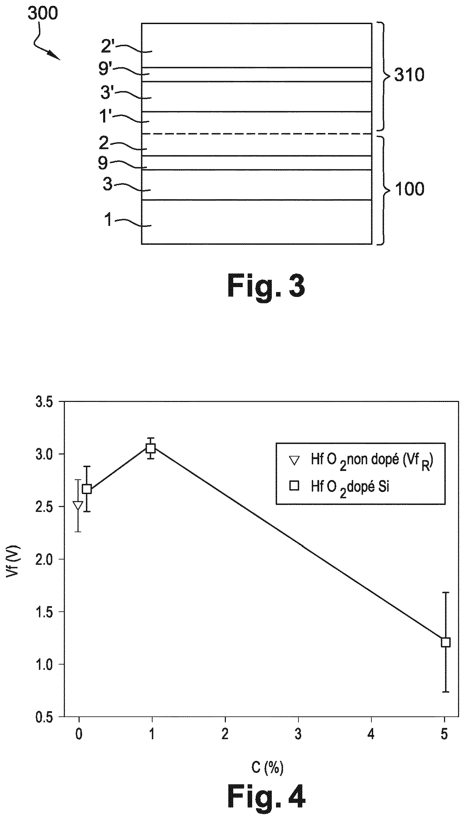

La figure 3 montre un mode de réalisation particulièrement avantageux d'une cellule élémentaire 300 selon l'invention dans lequel la cellule mémoire 310 présente une structure similaire à celle du dispositif de sélection 100. La cellule mémoire 310 comporte une couche d'oxyde 3' disposée entre une première électrode 1' et une deuxième électrode 2'. Par conséquent, la cellule mémoire et le dispositif de sélection peuvent être intégrés ensemble et réalisés au moyen de procédés similaires.

Les électrodes 1', 2' de la cellule mémoire 310 sont des couches conductrices électriquement et peuvent comporter un ou plusieurs matériaux conducteurs tels que le nitrure de titane, le silicium dopé, le tungstène, le nitrure de tungstène, les siliciures de métal, le platine. Les électrodes 1', 2' présentent une épaisseur de préférence comprise entre 5nm et 30nm.

La couche d'oxyde 3' de la cellule mémoire 310 comporte de préférence un oxyde d'un métal de transition tel que l'oxyde de hafnium, l'oxyde de tantale, l'oxyde de titane, l'oxyde de zirconium ou l'oxyde de niobium. Eventuellement, la couche d'oxyde 3' peut comporter plusieurs sous-couches d'oxydes superposées. La couche d'oxyde 3' présente une épaisseur de préférence comprise entre 3nm et 20nm, et plus préférentiellement encore comprise entre 5nm et 10nm.

Dans le mode de réalisation illustré à la figure 3, les électrodes 1, 2 du dispositif de sélection 100 et les électrodes 1', 2' de la cellule mémoire 310 sont en nitrure de titane, la couche d'oxyde 3 du dispositif de sélection 100 et la couche d'oxyde 3' de la cellule mémoire 310 sont en oxyde de hafnium. Ainsi, la fabrication de la cellule élémentaire 300 est simplifiée par l'utilisation de matériaux identiques pour réaliser le dispositif de sélection 100 et la cellule mémoire 310.

La cellule mémoire 310 peut basculer de manière réversible entre un état à faible résistance et un état à forte résistance qui correspondent à la formation et à la rupture d'une zone de commutation conducteur dans la couche d'oxyde 3'. Lorsque la cellule mémoire 310 se trouve dans son état original, juste après sa fabrication, la zone de commutation est formée pour la première fois en appliquant à la cellule mémoire 310 une première tension de formation. Ensuite, la cellule mémoire 310 entre dans un mode de fonctionnement normal dans lequel une tension d'écriture et une tension d'effacement sont utilisées respectivement pour former et rompre la zone de commutation, et ainsi changer l'état de résistance de la cellule mémoire 310. L'état de résistance dans lequel se trouve la cellule mémoire 310 peut être déterminé en lui appliquant une tension de lecture. Les tensions d'écriture, d'effacement et de lecture de la cellule mémoire 310 sont en valeurs absolues inférieures à la première tension de formation.

Sur le même principe, le dispositif de sélection 100, qui a une structure similaire à celle de la cellule mémoire 310, présente une deuxième tension de formation d'une zone de commutation dans la couche d'oxyde 3. Pour que le dispositif de sélection 100 conserve ses propriétés résistives et continue de fonctionner en tant que dispositif de sélection, et non comme une cellule mémoire, il est nécessaire d'éviter la formation de la zone de commutation. Pour ce faire, la tension appliquée au dispositif de sélection 100 est maintenue inférieure à la deuxième tension de formation. La première tension de formation de la cellule mémoire 310 est donc inférieure à la deuxième tension de formation du dispositif de sélection 100. Pour ce faire, on ajuste de préférence le dopage de la couche d'oxyde 3 du dispositif de sélection 100.

Le fait de doper la couche d'oxyde de telles structures avec un élément appartenant à la colonne IV de la classification périodique modifie la tension de formation de la zone de commutation dans cette couche. Plusieurs variantes du mode de réalisation de la figure 3 sont donc possibles, la couche d'oxyde 3' de la cellule mémoire 310 pouvant également dopée avec un deuxième élément appartenant à la colonne IV de la classification périodique. Le deuxième élément peut être identique ou différent à l'élément dopant la couche d'oxyde 3 du dispositif de sélection 100. Dans le mode de réalisation illustré à la figure 3, le silicium est utilisé pour doper les couches d'oxydes 3, 3' du dispositif de sélection 100 et de la cellule mémoire 310.

Le dopage de la couche d'oxyde 3,3' avec un élément appartenant à la colonne IV de la classification périodique modifie la tension de formation de la façon suivante. La tension de formation lorsque la concentration atomique de l'élément dopant est nulle, c'est-à-dire lorsque la couche d'oxyde 3, 3' n'est pas dopée, est prise comme tension de référence. Lorsque le dopage de la couche d'oxyde 3, 3' débute, la tension de formation augmente avec la concentration atomique jusqu'à atteindre une valeur maximale. Ensuite, lorsque la concentration atomique continue d'augmenter, la tension de formation diminue, en passant sous la tension de référence.

Ce phénomène est par exemple illustré sur la courbe de la figure 4 qui représente la variation de la tension de formation $V_f$ mesurée dans de l'oxyde de hafnium en fonction de la concentration atomique C en silicium présent dans l'oxyde de hafnium. Dans cet exemple, la tension de formation $V_f$ est supérieure à la tension de référence $V_{fR}$ lorsque la concentration C en silicium est comprise entre 0,1% et 2%, et la valeur maximale de la tension de formation $V_f$ semble être atteinte pour une concentration C en silicium de l'ordre de 1%. Au contraire, la tension de formation $V_f$ est inférieure à la tension de référence $V_{fR}$ lorsque la concentration C en silicium est supérieure à 2%.

Dans une première variante de la cellule élémentaire 300, la concentration atomique en silicium dans la couche d'oxyde 3 du dispositif de sélection 100 est comprise entre 0,5% et 2%, et la couche d'oxyde 3' est non dopée. Ainsi, une seule étape d'implantation peut suffire lors de la fabrication de la cellule élémentaire 300.

Dans une deuxième variante de la cellule élémentaire 300, la concentration atomique en silicium dans la couche d'oxyde 3 du dispositif de sélection 100 est supérieure à 2%, et la couche d'oxyde 3' de la cellule mémoire 310 est dopée de manière à présenter une concentration atomique en silicium supérieure à la concentration atomique en silicium dans la couche d'oxyde 3 du dispositif de sélection 100.

Dans les variantes décrites précédemment, les couches d'oxydes 3, 3' du dispositif de sélection 100 et de cellule mémoire 310 présentent des épaisseurs identiques. Il est également possible d'ajuster les tensions de formation du dispositif de sélection 100 et de cellule mémoire 310 en modifiant l'épaisseur des couches d'oxyde 3, 3'. Plus l'épaisseur d'une couche d'oxyde est grande, plus la tension de formation est élevée.

Le fait que la première tension de formation de la cellule mémoire 310 soit inférieure à la deuxième tension de formation du dispositif de sélection 100 peut être généralisé à d'autres types de cellules mémoires. Ainsi, la tension de fonctionnement la plus élevée d'une cellule mémoire est inférieure à la tension de formation de la zone de commutation dans la couche d'oxyde du dispositif de sélection associé à cette cellule mémoire.

Dans les cellules mémoires de type OxRam, une explication à la formation de la zone de commutation est l'accumulation de lacunes d'oxygène au sein de la couche d'oxyde 3'. Avantageusement, la cellule mémoire 310 peut comporter une couche 9' formée avec un matériau ayant une forte affinité avec l'oxygène, cette couche formant ainsi un réservoir de lacunes d'oxygène qui facilite la formation de la zone de commutation en fournissant les lacunes nécessaires. La couche de réservoir 9' est par exemple disposée entre la couche d'oxyde 3' et la deuxième électrode 2' de la cellule mémoire 310.

De même, le dispositif de sélection 100 peut avantageusement comporter une couche 9 formée avec un matériau ayant une forte affinité avec l'oxygène, cette couche formant ainsi un réservoir de lacunes d'oxygène. Dans ce cas, même avant la formation de la zone de commutation, la couche de réservoir 9 fournit des lacunes d'oxygène ce qui permet d'augmenter les valeurs du courant traversant le dispositif de sélection 100 pendant le fonctionnement. La couche de réservoir 9 est par exemple disposée entre la couche d'oxyde 3 et la deuxième électrode 2 du dispositif de sélection 100, comme illustré sur les figures 1 et 3.

Les couches de réservoir 9, 9' présentent une épaisseur de préférence comprise entre 2nm et 10nm, et plus préférentiellement encore comprise entre 3nm et 7nm. Les couches de réservoir 9, 9' comportent par exemple du titane, du zirconium, du hafnium ou du lanthane.

Le dispositif de sélection 100 et la cellule mémoire 310 sont disposés en surface d'un substrat (non représenté), par exemple en silicium, pouvant comporter d'autres couches déjà formées dessus. De préférence, les différentes couches constitutives du dispositif de sélection 100 et de la cellule mémoire 310 forment un empilement vertical par rapport à la surface du substrat. Le dispositif de sélection 100 et la cellule mémoire 310 peuvent ainsi avoir une électrode commune disposée entre les deux couches d'oxydes 3, 3'.

Dans le mode de réalisation illustré à la figure 3, le dispositif de sélection 100 est disposé entre la cellule mémoire 310 et le substrat. La couche d'oxyde 3 du dispositif de sélection 100 est ainsi située plus en profondeur que la couche d'oxyde 3' de la cellule mémoire 310. De cette manière, il est possible de doper à la fois la couche d'oxyde 3 du dispositif de sélection 100 et la couche d'oxyde 3' de la cellule mémoire 310 en deux implantations successives. Le profil de dopage désiré peut être obtenu en effectuant une première implantation à une énergie élevée, par exemple comprise entre 25 keV et 40 keV, afin de doper simultanément les deux couches d'oxyde 3, 3', et une deuxième implantation à une énergie faible, par exemple comprise entre 2 keV et 7 keV, afin de doper seulement la couche d'oxyde 3' de la cellule mémoire 310. La couche d'oxyde 3' de la cellule mémoire 310 cumule alors les dopants de la première implantation et de la deuxième implantation, et il en résulte que sa concentration atomique en dopants est supérieure à celle de la couche d'oxyde 3 du dispositif de sélection 100.

Naturellement, l'invention n'est pas limitée aux modes de réalisation décrits en référence aux figures et des variantes pourraient être envisagées sans sortir du cadre de l'invention.

Dans une variante de réalisation de la cellule élémentaire dans laquelle le dispositif de sélection et la cellule mémoire forment aussi un empilement vertical par rapport à la surface du substrat, la cellule mémoire peut être disposée entre le dispositif de sélection et le substrat.

Alternativement, les différentes couches constitutives du dispositif de sélection et de la cellule mémoire peuvent former un empilement horizontal par rapport à la surface du substrat. Le dispositif de sélection et la cellule mémoire sont alors l'un à côté de l'autre. L'électrode commune au dispositif de sélection et à la cellule mémoire est ainsi plus facilement accessible. Cette électrode peut être utilisée pour polariser indépendamment le dispositif de sélection et la cellule mémoire, par exemple pour garantir que la tension appliquée au dispositif de sélection reste inférieure à sa tension de formation.

## Revendications

1. Dispositif de sélection (100) d'une cellule mémoire non volatile résistive (310), le dispositif comportant une première électrode (1), une deuxième électrode (2) et une couche d'oxyde (3) disposée entre la première électrode et la deuxième électrode, le dispositif étant **caractérisé en ce que** la couche d'oxyde (3) est dopée avec du silicium.

2. Dispositif (100) selon la revendication 1 **caractérisé en ce que** la couche d'oxyde (3) est entièrement dopée avec le silicium

3. Dispositif (100) selon l'une quelconque des revendications 1 à 2 **caractérisé en ce que** le silicium est présent dans la couche d'oxyde (3) à une concentration atomique (C) comprise entre 0,5% et 3%.

4. Dispositif (100) selon l'une quelconque des revendications 1 à 3 **caractérisé en ce que** la couche d'oxyde (3) comporte un matériau parmi les suivants : oxyde de hafnium, oxyde de tantale.

5. Cellule élémentaire (300) **caractérisée en ce qu'**elle comporte un dispositif (100) selon l'une quelconque des revendications 1 à 4 et une cellule mémoire (310) non volatile résistive connectée en série avec le dispositif.

6. Cellule élémentaire (300) selon la revendication 5 **caractérisée en ce que** la cellule mémoire (310) est une cellule mémoire de type OxRAM, CBRAM ou PCRAM.

7. Cellule élémentaire (300) selon l'une quelconque des revendications 5 à 6 **caractérisée en ce que** la cellule mémoire (310) comporte une première électrode (1'), une deuxième électrode (2') et une couche d'oxyde (3') disposée entre la première électrode et la deuxième électrode, la cellule mémoire et le dispositif (100) présentant chacun une tension de formation d'une zone de commutation dans leur couche d'oxyde respective, la couche d'oxyde (3) du dispositif étant dopée de manière à ce que la tension de formation du dispositif soit supérieure à la tension de formation de la cellule mémoire.

8. Cellule élémentaire (300) selon la revendication 7 **caractérisée en ce que** le silicium est présent dans la couche d'oxyde (3) du dispositif (100) à une concentration atomique comprise entre 0,5% et 2%.

9. Cellule élémentaire (300) selon la revendication 7 **caractérisée en ce que** le silicium est présent dans la couche d'oxyde (3) du dispositif (100) à une concentration atomique supérieure à 2%, et **en ce que** la couche d'oxyde (3') de la cellule mémoire (310) est dopée avec un deuxième élément appartenant à la colonne IV de la classification périodique de manière à ce que le deuxième élément soit présent dans la couche d'oxyde de la cellule mémoire à une concentration atomique supérieure à la concentration atomique du silicium.

10. Cellule élémentaire (300) selon la revendication 9 **caractérisée en ce que** la couche d'oxyde (3') de la cellule mémoire (310) est dopée avec du silicium.

11. Cellule élémentaire (300) selon l'une quelconque des revendications 7 à 10 **caractérisée en ce que** le dispositif (100) et la cellule mémoire (310) sont disposés sur un substrat de manière à former un empilement vertical, le dispositif étant disposé entre la cellule mémoire et le substrat.

12. Cellule élémentaire (300) selon l'une quelconque des revendications 7 à 11 **caractérisé en ce que** la couche d'oxyde (3') de la cellule mémoire (310) comporte un matériau parmi les suivants : oxyde de hafnium, oxyde de tantale, oxyde de titane.

## Patentansprüche

1. Auswahlvorrichtung (100) einer nicht flüchtigen, ohmschen Speicherzelle (310), wobei die Vorrichtung eine erste Elektrode (1), eine zweite Elektrode (2) und eine Oxidschicht (3) umfasst, die zwischen der ersten Elektrode und der zweiten Elektrode angeordnet ist, wobei die Vorrichtung **dadurch gekennzeichnet ist, dass** die Oxidschicht (3) mit Silizium dotiert ist.

**2.** Vorrichtung (100) gemäß Anspruch 1, **dadurch gekennzeichnet, dass** die Oxidschicht (3) komplett mit Silizium dotiert ist.

**3.** Vorrichtung (100) gemäß irgendeinem der Ansprüche 1 bis 2, **dadurch gekennzeichnet, dass** das Silizium in der Oxidschicht (3) in einer zwischen 0,5 % und 3 % inbegriffenen Atomkonzentration (C) vorhanden ist.

**4.** Vorrichtung (100) gemäß irgendeinem der Ansprüche 1 bis 3, **dadurch gekennzeichnet, dass** die Oxidschicht (3) ein Material aus den folgenden umfasst: Hafniumoxid, Tantaloxid.

**5.** Einzelzelle (300), **dadurch gekennzeichnet, dass** sie eine Vorrichtung (100) gemäß irgendeinem der Ansprüche 1 bis 4 und eine nicht flüchtige, ohmsche Speicherzelle (310) umfasst, die in Serie an die Vorrichtung angeschlossen ist.

**6.** Einzelzelle (300) gemäß Anspruch 5, **dadurch gekennzeichnet, dass** die Speicherzelle (310) eine Speicherzelle vom Typ OxRAM, CBRAM oder PCRAM ist.

**7.** Einzelzelle (300) gemäß irgendeinem der Ansprüche 5 bis 6, **dadurch gekennzeichnet, dass** die Speicherzelle (310) eine erste Elektrode (1'), eine zweite Elektrode (2') und eine Oxidschicht (3') umfasst, die zwischen der ersten Elektrode und der zweiten Elektrode angeordnet ist, wobei die Speicherzelle und die Vorrichtung (100) jeweils eine Bildungsspannung einer Schaltzone in ihrer jeweiligen Oxidschicht aufweisen, wobei die Oxidschicht (3) der Vorrichtung derart dotiert ist, dass die Bildungsspannung der Vorrichtung größer ist als die Bildungsspannung der Speicherzelle.

**8.** Einzelzelle (300) gemäß Anspruch 7, **dadurch gekennzeichnet, dass** das Silizium in der Oxidschicht (3) der Vorrichtung (100) in einer zwischen 0,5 % und 2 % inbegriffenen Atomkonzentration vorhanden ist.

**9.** Einzelzelle (300) gemäß Anspruch 7, **dadurch gekennzeichnet, dass** das Silizium in der Oxidschicht (3) der Vorrichtung (100) in einer Atomkonzentration von mehr als 2 % vorhanden ist und dass die Oxidschicht (3') der Speicherzelle (310) mit einem zweiten Element dotiert ist, das zur Spalte VI der periodischen Einstufung gehört, derart, dass das zweite Element in der Oxidschicht der Speicherzelle in einer Atomkonzentration von mehr als der Atomkonzentration des Siliziums vorhanden ist.

**10.** Einzelzelle (300) gemäß Anspruch 9, **dadurch gekennzeichnet, dass** die Oxidschicht (3') der Speicherzelle (310) mit Silizium dotiert ist.

**11.** Einzelzelle (300) gemäß irgendeinem der Ansprüche 7 bis 10, **dadurch gekennzeichnet, dass** die Vorrichtung (100) und die Speicherzelle (310) derart auf einem Substrat angeordnet sind, dass eine vertikale Stapelung gebildet ist, wobei die Vorrichtung zwischen der Speicherzelle und dem Substrat angeordnet ist.

**12.** Einzelzelle (300) gemäß irgendeinem der Ansprüche 7 bis 11, **dadurch gekennzeichnet, dass** die Oxidschicht (3') der Speicherzelle (310) ein Material aus den folgenden umfasst: Hafniumoxid, Tantaloxid, Titanoxid.

**Claims**

**1.** Device for selecting (100) a resistive non-volatile memory cell (310), the device comprising a first electrode (1), a second electrode (2) and an oxide layer (3) arranged between the first electrode and the second electrode, the device being **characterised in that** the oxide layer is doped with silicon.

**2.** Device (100) according to claim 1 **characterised in that** the oxide layer (3) is entirely doped with silicon.

**3.** Device (100) according to any of claims 1 to 2 **characterised in that** the silicon is present in the oxide layer (3) at an atomic concentration (C) comprised between 0.5% and 3%.

**4.** Device (100) according to any of claims 1 to 3 **characterised in that** the oxide layer (3) comprises a material among the following: hafnium oxide, tantalum oxide.

**5.** Elementary cell (300) **characterised in that** it comprises a device (100) according to any of claims 1 to 4 and a resistive non-volatile memory cell (310) connected in series with the device.

**6.** Elementary cell (300) according to claim 5 **characterised in that** the memory cell (310) is a memory cell of OxRAM, CBRAM or PCRAM type.

**7.** Elementary cell (300) according to any of claims 5 to 6 **characterised in that** the memory cell (310) comprises a first electrode (1'), a second electrode (2') and an oxide layer (3') arranged between the first electrode and the second electrode, the memory cell and the device (100) each having a voltage for forming a switching zone in their respective oxide layer, the oxide layer (3) of the device being doped in such a way that the form ing voltage of the device is greater than the form ing voltage of the memory cell.

8. Elementary cell (300) according to claim 7 **characterised in that** the silicon is present in the oxide layer (3) of the device (100) at an atomic concentration comprised between 0.5% and 2%.

9. Elementary cell (300) according to claim 8 **characterised in that** the silicon is present in the oxide layer (3) of the device (100) at an atomic concentration greater than 2%, and **in that** the oxide layer (3') of the memory cell (310) is doped with a second element from column IV of the periodic table in such a way that the second element is present in the oxide layer of the memory cell at an atomic concentration greater than the atomic concentration of the silicon.

10. Elementary cell (300) according to claim 9 **characterised in that** the oxide layer (3') of the memory cell (310) and the oxide layer (3) of the device (100) are doped with silicon.

11. Elementary cell (300) according to any of claims 8 to 11 **characterised in that** the device (100) and the memory cell (310) are arranged on a substrate in such a way as to form a vertical stack, the device being arranged between the memory cell and the substrate.

12. Elementary cell (300) according to any of claims 8 to 12 **characterised in that** the oxide layer (3') of the memory cell (310) comprises a material among the following: hafnium oxide, tantalum oxide, titanium oxide.

**Fig. 1**

**Fig. 2**

**Fig. 3**

**Fig. 4**

**EP 3 510 598 B1**

## RÉFÉRENCES CITÉES DANS LA DESCRIPTION

**Documents brevets cités dans la description**

- US 2015263069 A1